# EUROPEAN PATENT SPECIFICATION

(11) **EP 2 180 326 B1**
(45) Date of publication and mention of the grant of the patent: **03.05.2017**
(21) Application number: 08018642.2
(22) Date of filing: 24.10.2008
(51) Int. Cl.: G01R 1/067, H01R 103/00, H01R 13/24, H01R 24/40, H01R 13/631

(54) **Test probe**
Testsonde
Sonde de test

(43) Date of publication of application: 28.04.2010
(73) Proprietor: Tyco Electronics Services GmbH, 8200 Schaffhausen (CH)
(72) Inventor: Bozzer, Dieter, 6984 Pura (CH); Lanfranconi, Giuseppe, 22010 Carlazzo (IT); Heutschi, Sigfrido, 6982 Agno (CH); Scheggia, Mattia, 6912 Pazzallo (CH)
(74) Representative: Grünecker Patent- und Rechtsanwälte PartG mbB

(56) References cited:
- WO-A-00/31835
- GB-A- 2 336 948
- JP-A- 10 221 368
- US-A- 4 815 986
- US-A- 5 196 789
- US-A- 5 769 652
- US-A- 5 982 187
- US-A1- 2004 175 978
- US-A1- 2006 051 997

## Description

The invention relates to a test probe for mating with a connector in a probe insertion direction, comprising: a housing, an outer contact portion, the outer contact portion supported by the housing and extending away from the housing, said outer contact portion supported by an elastically deformable outer biasing means and being adapted to be deflected substantially perpendicular to the probe insertion direction and at least one contact assurance means, said contact assurance means connecting the outer contact portion electrically conductively to the housing and having at least one contact section, said contact section pressed conductively against the housing by being elastically deflected.

Test probes are used for the in circuit functional testing of printed circuit boards (PCBs). A variety of tip styles and materials are available to suit just about every application. For electrically connecting PCBs to probes connectors are mounted on PCBs. As the size of integrated circuitry components is reduced and the package density on printed circuit boards is increased, the remaining space for arranging connectors is reduced. Thus, coaxial connectors are minimized.

While testing a PCB assembly, many connections between test probes and connectors on the PCB may need to be built up simultaneously. As the connectors to be probed on the PCB can be very close to each other, it is also required that the probes can be arranged close to each other to allow for testing the PCB assembly within one step.

US 4,764,722 describes a coaxial probe with a flexible inner conductor that is housed within a conductive outer sheet. The inner conductor buckles upon the application of an axial load. A significant shortcoming of these prior art probes is that they require precise alignment to mating connectors on printed circuit boards. The allowable misalignment of probes becomes smaller as probes are increasingly miniaturized.

To assure a reliable contact between the probe and the connector on the PCB, the state of the art provides test probes with movable inner and outer contact portions, which can be deflected perpendicular to the insertion direction and move independently in or against the insertion direction.

US 2006/0051997 A1 discloses a coaxial connector, having a spring-supported, movable housing which comprises an inner and an outer contact portion. The inner and the outer contact portions are affixed to each other through insulators.

US 5,769,652 A discloses a coaxial connector including an inner and an outer contact portion which can float relative to each other.

A problem which arises from the state of the art is that, in particular at a deflected state of the contact portions, the electrical contact between the contact portions and the connected testing device, i.e. the electrical conductors of the test probe, can be broken.

To avoid a loss and to increase the reliability of the electrical contact according to the invention, the contact assurance means is received by the housing slidingly in the insertion direction. This solution allows for a movement of the outer and/or the inner contact portion in or against the insertion direction of the test probe.

For facilitating a deflection of the outer contact portion perpendicular to a probe insertion direction and to assure the electrical contact between the housing and the outer contact portion also in a deflected position of the outer contact portion, the contact assurance means may be adapted to rotate substantially perpendicularly to a probe insertion direction. The contact assurance means can be disposed in a recess of the housing which has a substantially cylindrical shape.

To allow for a movement of the contact assurance means in or against insertion direction 1, the contact assurance means can be at least in sections shaped like a piston for guiding the sliding movement of the contact assurance means. To allow the contact assurance means to elbow or to rotate in relation to the housing, its piston shaped section may have an outer diameter that is a little bit smaller than the inner diameter of the housings recess.

To increase the reliability of the electrical contact between the contact assurance means and the outer contact portion, the outer biasing means can be adapted to generate a restoring force upon deformation, the contact assurance means interposed between the outer biasing means and the outer contact portion in the restoring force flux.

In a further advantageous embodiment of the invention, the test probe can comprise at least one guiding element, said guiding element arranged moveable in an axial direction in the guiding recess and disposed in the force flux which is directed from the outer biasing means to the contact assurance means. The guiding element can have a protrusion or a recess for receiving the outer biasing means and for guiding the outer biasing means in an axial direction parallel to the insertion direction.

To increase the contact force exerted from the contact assurance means onto the housing or to increase the elastical deflection of the contact section, the guiding element can be adapted to spread or to buckle the contact assurance means when a mating force acts onto the housing. Alternatively or additionally, the support portion can be adapted to spread or to buckle the contact assurance means when the test probe is mated.

The guiding element may have a face abutting the contact assurance means, said face having a conical or rounded shape serving as bearing surface and allowing the contact assurance means to rotate perpendicular to the insertion direction I. Alternatively or additionally, the contact assurance means may have a conical or rounded face abutting the guiding element. The contact assurance means can have a recess for receiving at least a portion of the guiding element. The recess can have a conical or a rounded shape abutting the received portion of the guiding element and allowing the contact assurance means to slant or rotate in relation to the housing and the guiding element.

In order to allow a deflection of the outer contact portion in relation to the housing, the outer contact portion can have a support portion, said support portion arranged within the housing and at an initial state of the test probe pressed by the outer biasing means onto a support face of the housing, the support portion and/or support face adapted to generate an aligning force to align the contact portion with the insertion direction.

As the outer surface of the outer contact portion can abut the housing at the opening receiving the outer contact portion or within the receiving recess of the housing, the maximum deflection of the outer contact portion, perpendicular to the insertion direction I, depends on the length of the outer contact portion which is moved into the housing. To increase the maximum deflection of the outer contact portion, an external dimension of the outer contact portion is at least in one section situated adjacent to the support portion, tapering in insertion direction. Thus, the outer contact portion can be adapted to provide a constant maximum deflection relative to the housing of the end of the outer contact portion pointing in insertion direction.

The alignment of the inner contact portion to a counter connector may be improved by an inner contact portion which is adapted to be moveable in an axial direction, independently of the outer contact portion. The inner contact portion can be connected to the housing by an elastically deformable inner biasing means, said inner biasing means being adapted to exert a restoring force on the inner contact portion, said restoring force directed to the insertion direction.

To transmit the restoring force from the inner biasing means to the inner contact portion, and/or to provide a reliable electrical contact between the inner contact portion and an inner interface portion for connecting the test probe to a test device, the test probe can comprise a guidance and an inner guiding element, said guidance having an inner guiding recess, the inner guiding element connected moveably in an axial direction to the inner guiding recess, the inner guiding element extending away from the guidance in insertion direction and transmitting the restoring force from the inner biasing means to the inner contact portion.

In a further advantageous embodiment the guiding element may have a recess adapted to receive at a mated state of the test probe at least a portion of the guidance. The guiding element and the guidance may fit into each other and thereby provide space within the housing, increasing the maximum movement of the outer and/or the inner contact portion into the housing.

To limit the movement of the outer and/or the inner contact portion into the housing and to avoid damage of the test probe, the guidance may be provided with a stop, said stop adapted to interfere with the guiding element at a predetermined end position of the guiding element.

The test probe according to the invention allows for an increased miniaturization of test probes. The section of the outer contact portion and/or the inner contact portion extending out of the housing can have a length of circa 12mm. The ratio of the largest diameter to the length in insertion direction of the section of the outer contact portion extending out of the housing can be about 6.

An end of the outer contact portion pointing in insertion direction and/or an end of the inner contact portion can be adapted to be deflected in a radial direction, substantially perpendicular to the probe insertion direction, up to at least 0,5mm. In particular, the ratio of the maximum deflection perpendicular to the insertion direction of the end of the outer contact portion, said end pointing to the insertion direction, to the largest diameter of the section of the outer contact portion extending out of the housing may be about 1/24 to 4/24, preferably 1/8. The ratio of the maximum upstroke of the insertion portion to the length of the housing in insertion direction can be about 2/15 to 4/15, preferably 1/5.

In spite of the small dimensions of the test probe, the outer contact portion and/or the inner contact portion can be adapted to be deflected in an axial direction up to at least 2 mm. In particular, the outer contact portion and/or the inner contact portion can be adapted to be deflected in an axial direction up to at least ½ length of the section of the outer contact portion extending out of the housing.

To allow for centering the outer contact portion in relation to a counter connector, the end of the outer contact portion pointing in insertion direction can be substantially cone shaped. The cone shaped end can taper in insertion direction, corresponding to a funnel shaped insertion opening of the counter connector. Thus, a mating force acting on the test probe in insertion direction results in an aligning force, pushing a centre axis of the outer connector in direction of a centre axis or mating axis of the counter connector. Alternatively, the end of the outer contact portion may be provided with a funnel shaped recess, corresponding to a cone shaped protrusion of the counter connector.

For facilitating connecting the test probe to a test device, the test probe can have a connector portion, said connector portion comprising an outer and an inner interface portion, the outer and the inner interface portion forming a coaxial plug.

The invention will be described hereinafter in greater detail and in an exemplary manner using advantageous embodiments and with reference to the drawings. The described embodiments are only possible configurations in which, however, the individual features as described above, can be provided independently of one another or can be omitted. In the drawings:
Fig. 1 is a schematic side view of a test probe configured according to the invention;
Fig. 2 is a cross sectional view of the test probe according to Fig. 1;
Fig. 3 is an enlarged cross sectional view of section III of the embodiment according to Fig. 1;
Fig. 4 is an enlarged perspective view of a contact element according to the invention;
Fig. 5 is an enlarged cross sectional view of section V of the embodiment according to Fig. 1;
Fig. 6 is an enlarged top view of the first exemplary embodiment according to Fig. 1;
Fig. 7 is an enlarged side view of section VII according to Fig. 1;
Fig. 8 is an enlarged cross sectional view of section VIII of Fig. 2
Fig. 9 shows an enlarged cross sectional view of an end of a test probe according to the embodiment of Fig. 1 and a cross sectional view of a connector, the test probe arranged to mate the connectors;
Fig. 10 shows the test probe and the connector according to Fig. 8 in a mating position;
Fig. 11 is a cross sectional view of a middle section of the embodiment according to Fig. 1;
Fig. 12 is a perspective view of a plurality of test probes mounted within a testing device.

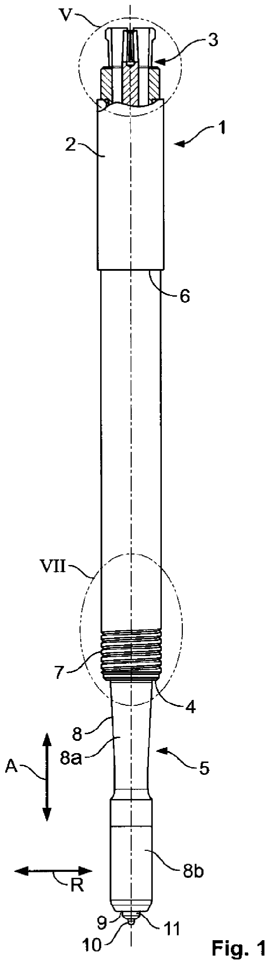

First of all, the embodiment of a test probe configured according to the invention will be described with reference to Fig. 1, which shows a schematic side view of an exemplary embodiment.

The test probe 1 comprises an elongated housing 2. For connecting the test probe 1 to a (not shown) test device the test probe 1 is provided with a connector portion 3 which is formed as a snap-on connection. At the lower end the housing 2 has an opening 4 wherein an insertion portion 5 is arranged.

The housing 2 has at its outer cylindrical surface a shoulder 6 which serves as stop when the test probe is mounted on a adaptor plate. For instance, the lower portion of the housing 2 which has the smaller outer diameter, can be inserted into a bore of a adaptor plate up to a position where the shoulder 6 rests on a corresponding shoulder of the adaptor plate. At the lower end of the lower portion of the housing 2 the housing 2 is provided with a screw thread for affixing the housing 2 to the adaptor plate. The screw thread 7 is positioned adjacent to the opening 4 so that the force flow resulting from forces acting onto the insertion portion 5, in particular from forces pointing to a radial direction R is guided on a direct way to the housing 2.

The insertion portion 5 comprises an outer contact portion 8 which consists of a proximal part 8a and a distal part 8b. At the lower end of the distal part 8b the insertion portion 5 has an opening 9 for receiving an inner contact portion 10 and a bearing element 11 which surrounds the inner contact portion 10.

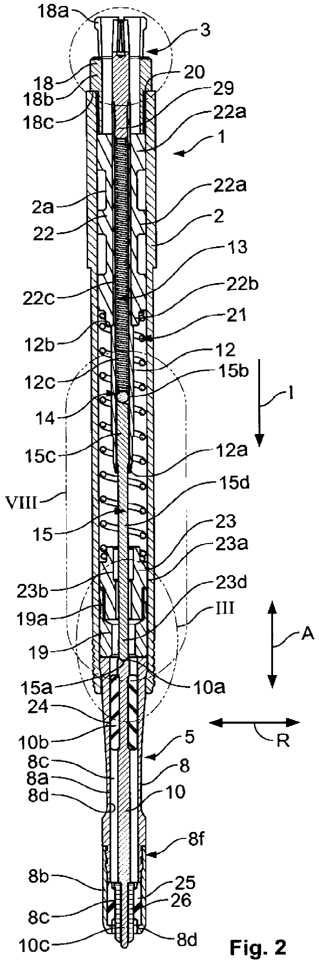

Fig. 2 is a cross sectional view of the embodiment according to Fig. 1. The test probe 1 can be connected to a counter connector (not shown) which is mounted on a printed circuit board or an arbitrary electrical device. The counter connector can be a switching connector, which opens or closes an electrical circuit when the test probe 1 is inserted into an insertion direction I.

When the test probe 1 is connected the current or test signal from the connector reaches the connector portion 3 of the test probe 1 through an inner conductor, the inner conductor disposed in a recess 2a of the housing 2. The inner conductor of the test probe 1 comprises a substantially cylindrical guidance 12, an inner biasing means 13, an inner contact body 14, a inner guiding element 15, the inner contact portion 10, and an inner interface portion 29 of the connector portion 3. The inner biasing means 13 is formed as a spiral spring, the inner contact body 14 as a ball. The guidance 12 is substantially tube shaped and provided as a cylindrical recess 17 which extends from the connector portion 3 to the inner guiding element 15. The inner biasing means 13 is arranged within the cylindrical 17 and preloaded to exert a restoring force onto the inner contact body 14 which transmits the restoring force onto the inner guiding element 15.

The inner guiding element 15 extends through an opening at the end of the guidance 12 pointing in insertion direction I up to the inner contact portion 10. The inner guiding element 15 abuts the inner contact portion 10 and thereby transmits the restoring force from the inner biasing means in insertion direction I to the inner contact portion 10. The inner contact portion 10 which can move independently in an axial direction A is thereby urged into insertion direction I.

An outer conductor or electromagnetic shielding of the test probe 1 comprises an outer interface portion 18, the housing 2, an contact assurance means 19 and the outer contact portion 8. The outer interface portion 18, outer plug conductor 18a and an outer ferrule 18b which connects the outer plug conductor 18a electrically to the housing 2. The outer interface portion 18 is provided with an shoulder 18c which rests on the edge at a first opening 20 of the substantially tube shaped housing 2. To allow for an elastic deflection of the outer plug conductor 18a is provided with slots extending in insertion direction I and splitting up the outer plug conductor into bendable beams.

To support the outer contact portion 8, the test probe 1 comprises an outer biasing means 21 which is formed as a spiral spring 21. The spiral spring itself is supported by an anchoring element 22 which is made from a dielectric material, preferably plastics, in particular PEEK or PTFE. Against insertion direction I the anchoring element 22 abuts the outer ferrule 18b. By mounting the outer ferrule 18b to the housing 2, for example by a clamp connection, the outer ferrule 18b may serve as support for the anchoring element 22. Additionally or alternatively, the outer ferrule 18b can be provided with a protrusion or a recess which engages with a protrusion or recess at the housing 2. Thus, the outer ferrule 18 can be connected to the housing by a form closure. A form closure allows for transmitting torques when the test probe is mounted.

The anchoring element 22 is provided with shoulders 22a which may be resiliently deformed to build up a force closure with the inner face of the housing 2. At its end pointing in insertion direction I the anchoring element 22 includes an protrusion 22b for receiving a closed ring of the outer biasing means 21 to support and to position the outer biasing means 21.

The outer biasing means exerts a restoring force in insertion direction I via a guiding element 23 and the contact assurance means 19 onto the outer contact portion 8. Thus, the outer biasing means 21 pushes the outer contact portion 8 onto the outer contact or shielding of a mating coaxial connector as well as the anchoring element 22 the guiding element 23 comprises an step 23a for receiving an end of the outer biasing means 21, preferably a closed ring at the end of the biasing means 21.

The outer contact portion 8 has a support portion 8i which is arranged within the housing 2. At the shown initial state of the test probe 2 the support portion 8i is pressed by the outer biasing means 21 onto a support face 2b of the housing 2. The support face 2b is substantially funnel shaped and tapering in insertion direction I. The support portion 8i is, corresponding to the support face 2b, substantially cone-shaped. Pressing the support portion 8i onto the funnel-shaped support face 2b results in aligning force directed perpendicular to the insertion direction and aligning a center axis Z of the outer contact portion 8 with a center axis X of the outer contact portion 10.

The step 23a serves as guiding portion 23a, at which the outer diameter of the guiding element 23 corresponds to the inner diameter of the housing 2. The guiding portion 23 may move in an axial direction A in or against insertion direction I, guiding the movement of the outer biasing means 21 as well as of the guiding element 23.

The contact assurance means 19 has a recess 19a adapted to receive a holding portion 23b of the guiding element 23. At the recess 19a the contact assurance means 19 has slots (here not shown) that allow for a resilient deflection of portions of the contact assurance means 19. The resilient deflection of the contact assurance means 19 at the recess 19a allows for a reliable electrical contact between the contact assurance means 19 and the housing 2.

The inner guiding element 15 passes the guiding element 23 through a cylindrical bore 23d. The end 15a of the inner guiding element 15 is rounded and extends into a wedge-shaped recess 10a of the inner contact portion 10. Alternatively, the end 15a could have a wedge-shaped recess and the end of the inner contact portion 10 pointing against insertion direction I could be rounded, the wedge shaped recess adapted to receive the rounded end of the inner contact portion 10. The inner contact portion 10 is surrounded by bearing elements 24 and 25 which serve for a sliding connection between the inner contact portion 10 and the outer contact portion 8. Additionally, the bearing elements 24, 25 are made of a dielectric material to insulate the inner contact portion 10 against the outer contact portion 8. The bushing-like bearing element 24 is arranged within a groove of the inner contact portion and thereby cannot be moved in relation to the inner contact portion 10. Thus, if the inner contact portion 10 is moved in an axial direction A the bearing element 24, whose outer diameter corresponds to an inner diameter of a recess 8c within the outer contact portion 8, slides on a inner surface 8d of the recess 8c.

The bearing element 25 is arranged in a recess 8c of the distal part 8b of the outer contact portion 8. The distal part 8b is formed like a cap which is connected to the proximal part by a form closure. Thereby, the distal part 8b facilitates the mounting of the test probe 1. Additionally the distal part 8b allows for an adaptation of the test probe 1 to various test configurations. Distal parts 8b with different dimensions can be mounted, in particular to adapt the resistance of the outer contact portion 8.

In insertion direction I the bearing element 25 rests on a shoulder 8d of the distal part 8b. Against insertion direction I the bearing element 25 abuts the proximal part 8a of the outer contact portion 8. As well as the bearing element 24 the bearing element 25 is made of dielectric material, insulating the inner contact portion 10 against the outer contact portion 8.

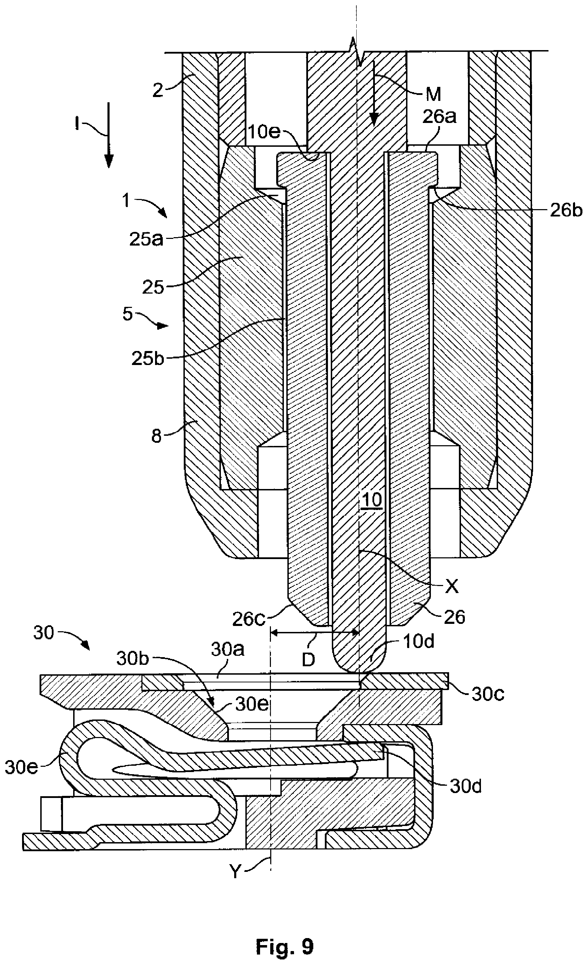

A distal end 10c of the inner contact portion 10 is surrounded by a bushing 26 which may be made of non-metallic material, in particular ceramics, e.g. alluminium oxide. The bushing 26 may slide on the inner contact portion 10 as described below with regard to fig. 9. Alternatively, the bushing 26 may be connected to the distal end 10c by a form closure, for instance by pressing the bushing 26 against insertion direction I onto the distal end 10c. In addition or alternatively, the bushing 26 can be connected to the inner contact portion 10 by an adhesive bond. When the inner contact portion 10 is moved in an axial direction A the bushing 26 slides within the cylindrical recess of the bearing element 25.

The distal part 8b of the outer contact portion 8 is connected to the proximal part 8a by a snap on connection 8f. At the snap-on connection 8f the distal part 8b and the proximal part 8a are provided with recesses and protrusions which are engaging each other. To mount the distal part 8b its end comprising the snap-on connection 8f is positioned at the end of the proximal part 8a and pushed against insertion direction I.

The anchoring element 22 provides support for the guidance 12 and for the outer biasing means 21. The anchoring element 22 has a recess 22c adapted to receive at least a section of the guidance 12. The anchoring element 22 which surrounds the guidance 12 may be molded over the guidance 12 to build up a form closure or a force closure. Alternatively, the guidance 12 may be pressed into the recess 22c up to a predetermined mounting position.

The guidance 12 comprises a shoulder 12b, which abuts the inner edge of the recess 22c and the protrusion 22b, respectively. The protrusion 22b which is formed as an extension 22b serves as centering for the outer biasing means 21.

The inner biasing means 13 exerts a restoring force onto the inner contact body 14. The restoring force pushes the inner contact body 14 in insertion direction I. As the inner contact body 14 is arranged on a slanted surface 15b at the end of the inner guiding element 15 a reaction force emerges due to the restoring force which is perpendicular to the slanted surface 15b. This reaction force has a component parallel to the insertion direction I and a component which is directed perpendicular to the insertion direction I. As the inner biasing means 13 and the inner contact body 14 are disposed within an inner guiding recess 12c, the component of the reaction force, which is perpendicular to the insertion direction I, pushes the inner contact body 14 against the inner surface of the hollow region 29.

Due to the inner contact body 14 bedded on the slanted surface 15b, a reliable electrical connection between the inner guiding element 15 and the guidance 12 is assured. As the inner biasing means 13 possibly has a too high resistance value the electrical connection between the inner contact portion 10 and the inner interface portion 29 is improved by using the guidance 12 as electrical conductor. Therefore, the inner contact body 14 is made of electrically conductive material for connecting the inner guiding element 15 electrically conductive to the guidance 12.

The inner guiding element 15 consists of two sections 15c, 15d with different diameters. The section 15c forms an inner guiding portion 15c, which abuts the inner contact body 14. The guiding portion 15c has a bigger diameter than section 15d, which extends in insertion direction I through an opening 12a out of the guidance 12, and is adapted to slide within the inner guiding recess 12c in an axial direction A. Thereby, the inner guiding portion 15d guides section 15d which is formed as a rod 15d in insertion direction I. To avoid that the inner guiding portion 15c runs out of the inner guiding recess 12c in insertion direction I, the opening 12a is smaller than the smallest diameter of the inner guiding portion 15c. When the inner guiding element 15 is moved in insertion direction up to a predetermined end position a face of the inner guiding element pointing substantially to insertion direction I hits a counter face of the guidance 12, surrounding section 15d and pointing substantially against insertion direction I.

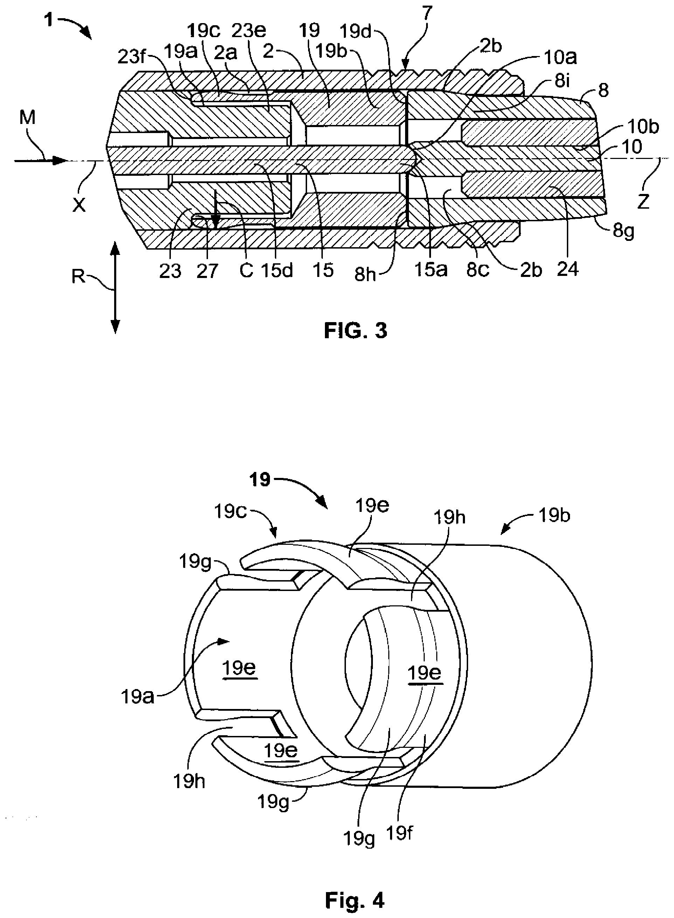

Fig. 3 is an enlarged view of section III in Fig. 1. To allow for pivoting of the inner contact portion 10 in relation to the inner guiding element 15, the inner guiding element 15 has a rounded end 15a which extends into a wedge-shaped recess 10a of the inner contact portion 10. Due to the rounded shape of the rounded end 15a the inner contact portion can be rotated transversely in an axial direction A without losing the electrical contact to the inner guiding element 15, as the inner guiding element 15 is urged by a restoring force from the inner biasing means in insertion direction I.

The inner contact portion 10 is surrounded by the bearing element 24, the bearing element 24 formed as a bushing and disposed slideable in the recess 8c. To facilitate inserting the bearing element 24 into the recess 8c of the outer contact portion 8, the edges of the cylindrical outer surfaces of the bearing element 24 are chamfered. The bearing element 24 may be made of a non-conductive material, in particular plastics, which is molded over the inner contact portion 10 at the groove 10b. Alternatively, the bearing element 24 can be provided with a slot extending in insertion direction from a first to a second end of the bearing element 24 to allow for a snap-fit connection between bearing element 24 and inner contact portion 10.

The guiding element 23 has a protrusion 23e extending into the recess 19a of the contact assurance means 19. As the inner diameter of the recess 19a is a little bit larger than the outer diameter of the protrusion 23e, a slot 27 remains which ensures the mobility of the contact assurance means 19.

The contact assurance means 19 comprises a guiding section 19b and a contact section 19c. At the substantially cylindrical guiding section 19b the outer diameter of the contact assurance means 19 is smaller than the diameter of the recess 2a of the housing 2, so as to enable a rotational movement of the contact assurance means 19 on a rotation axis that extends substantially transversely to the insertion direction I. At the contact section 19c the contact assurance means 19 abuts the inner face of the housing 2. The contact section 19c can be preloaded to generate a contact force C which assures the electrical contact or connection between the contact assurance means 19 and the housing 2.

As the housing 2 is a part of the outer conductor, which conducts the current from the outer contact portion 8 to the outer interface portion 18, the contact assurance means 19 increases the reliability of the electrical contact between the outer contact portion 8 and the outer interface portion 18. The electrical contact is assured when the outer contact portion 8 is moved against the insertion direction I into the recess 2a of the housing 2, even though the outer surface 8g of the outer contact portion 8 tapers in insertion direction I. The guiding element 23 transmits the restoring force generated by the outer biasing means 21 through shoulders 23f onto the contact assurance means 19. Thereby, the contact assurance means 19 is pushed in insertion direction I onto the outer contact portion 8, assuring the electrical contact between the front face 19d of the contact assurance means 19 and the front face 8h of the outer contact portion 8, also if the outer contact portion 8 is moved against insertion direction I into the housing 2.

In order to increase the contact force C exerted from the contact assurance means 19 onto the housing 2 or to increase the elastical deflection of the contact section 19c, the guiding element 23 can be adapted to spread or to buckle the contact assurance means 19 when a mating force M acts onto the housing 2. Alternatively or additionally, the support portion 8i can be adapted to spread or to buckle the contact assurance means 19 when the test probe is mated.

To increase the contact force C, which results from the restoring force of the outer biasing means 21, the shoulder 23f of the guiding element 23 may be cone-shaped, tapering in insertion direction I, so that the restoring force is split up in an axial and radial components, the radial components acting on the contact section 19c in radial directions R, widening the contact section 19c to press it against the inner surface of the recess 2a of the housing 2. Alternatively or additionally, the end of the contact section 19c of the contact assurance means 19 abutting the guiding element 23 can be funnel-shaped, tapering in insertion direction I.

The housing 2 is provided with a screw thread 7 positioned at the end of the housing pointing in insertion direction I. By this screw thread 7 the housing can be mounted on a test device or an adaptor plate which in operation, for mating the test probe 1 with a connector, is moved towards the connector.

Fig. 4 is an enlarged perspective view of the contact assurance means 19. The contact assurance means 19 is provided with a cylindrical guiding section 19b and a contact section 19c. The contact section 19c comprises resiliently deflectable support organs 19e. Each support organ 19e has a slim portion 19f for facilitating a resilient deformation of a support organ 19e and a thickened section 19g adapted to generate a reliable electrical contact to the housing of the test probe. To facilitate an elastic deformation of the support organs 19e, the support organs 19e are separated by slots 19h, enabling the contact section 19e to spread or to widen. Alternatively, the contact section 19e can be compressed by biasing the contact sections 19c resiliently into the direction of the center axis X. For a pre-stressed configuration of the support organs 19e within the housing of the test probe, the outer diameter of the contact assurance means 19 in the region of the contact section 19c, in particular at the support organs 19e, may be larger than the inner diameter of the recess 2a shown in Fig. 3.

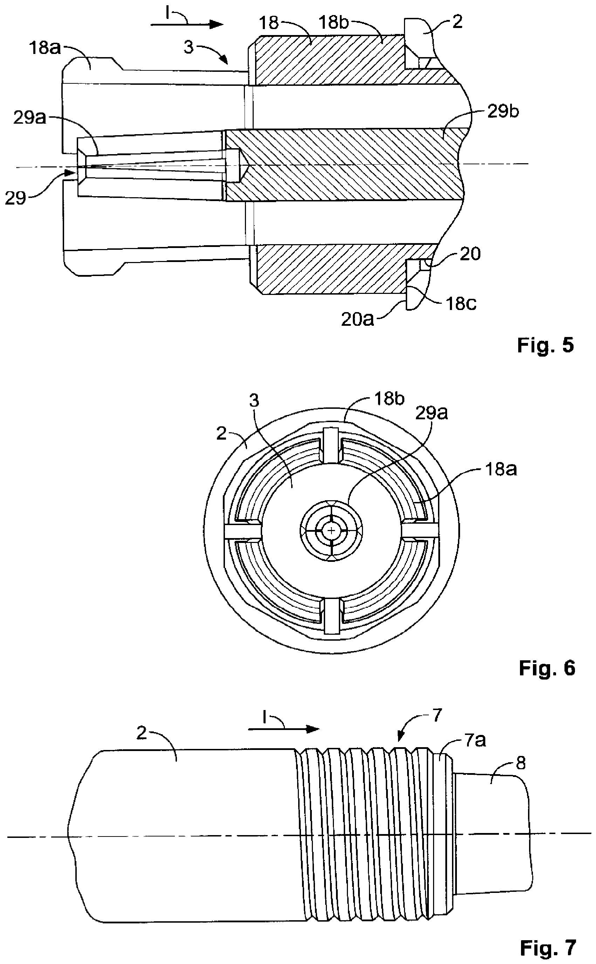

Fig. 5 is a cross sectional view of the connector portion 3 and corresponds to section V of Fig. 1. The connector portion 3 comprises an outer interface portion 18 and an inner interface portion 29. The outer interface portion 18 has an outer plug conductor 18a for connecting the test probe to the outer conductor of a coaxial plug connector. The outer interface portion 18 is electrically connected to the housing 2 by an outer ferrule 18b. The outer ferrule 18b has an offset 18c or shoulder 18c which abuts the shoulder 20a or edge 20a of the first opening 20 of the housing 2.

The connector portion 3 also comprises an inner interface portion 29, the inner interface portion 29 having an inner plug conductor 29a and an inner plug connector 29b. The outer plug connector 18a as well as the inner plug conductor 29a are provided with slots extending in insertion direction I, allow a resilient widening of the outer plug conductor 18a or the inner plug conductor 29a.

Fig. 6 is a side view of the test probe 1, showing the connector portion 3. The outer ferrule 18b has a substantially hexagonal shape, adapted to be mated with a hexagonal wrench key for mounting the test probe, in particular for screwing in the screw thread 7.

Fig. 7 is a side view of section VII in Fig. 1. The housing 2 is at its end pointing to insertion direction I provided with a screw thread 7 and a shoulder 7a. The shoulder 7a serves for centering the housing 2 in relation to a counter thread bore when the test probe is mounted on a testing device.

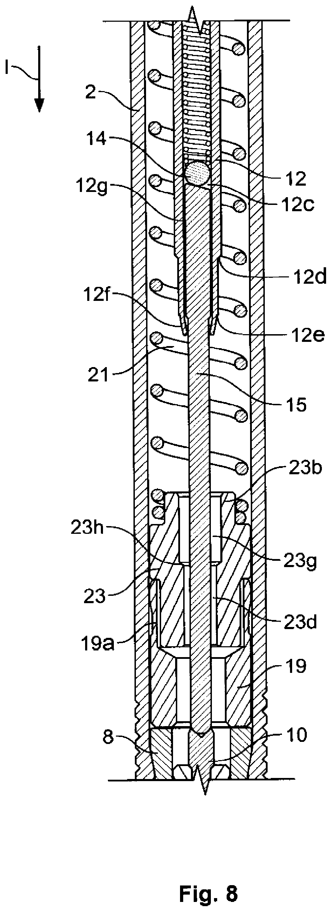

Fig. 8 is a cross sectional view of a middle section of the test probe according to Fig. 2. The guidance is provided with stops 12d and 12e which are formed as shoulders 12b and 12e. When the test probe is mated and moved in insertion direction I the outer contact portion 8 and/or the inner contact portion 10 are moved against insertion direction I relative to the housing 2 so that the guiding element 23 is moved upwards against insertion direction I up to the guidance 12. To avoid a damage of the guidance 12 and to elongate the maximal deflection of the outer contact portion 8 against the insertion direction I, the guiding element 23 is provided with recesses 23d and 23g for receiving stepped portions 12g and 12f of the guidance 12. At an end position of the outer contact portion 8, at which the maximum deflection against insertion direction I is reached, the stop 12e rests on a shoulder 23h at the bottom of a recess 23g. Additionally or alternatively, the shoulder 12d of the guidance 12 may be adapted to rest on a holding portion 23b when a maximal axial deflection of the outer contact portion 8 has been achieved.

Fig. 9 is a schematic view of the end of the test probe 1 set on a connector for mating the test probe 1. The bearing element 25 or dielectric 25 has an opening 25b for receiving the bushing 26. The bushing 26 may be arranged slidable in insertion direction I on the inner contact portion 10. To transmit at least a portion of the mating force M onto the bushing 26, the inner contact portion can be provided with a shoulder 10e, said shoulder 10e abutting a shoulder 26a of the bushing 26. In order to limit the sliding movement of the bushing 26 or to prevent the bushing 26 from moving outside the insertion portion 5, the bushing can comprise a step 26b pointing in insertion direction I. The step 26b can be adapted to abut a shoulder 25a of the bearing element, the shoulder 25a serving as stop 25a.

Both the test probe 1 and the connector 30 are shown in a schematic cross sectional view. The centre axis X of the test probe 1 is not aligned with a mating axis Y of the connector 30. The inner contact portion 10 has a rounded tip 10d which rests on a chamfered edge 30a of the insertion opening 30b. The insertion opening 30b comprises a funnel-shaped section 30f which is tapering in insertion direction I. The funnel-shaped section 30f corresponds to a tapered section 26c of the bushing 26, to align the centre axis X of the insertion portion 5 to the mating axis Y of the connector 30. A mating force M generated by a testing device acts on the test probe 1 in insertion direction I and presses the rounded tip 10d on the chamfered edge 30a, so that the tip 10d slides in the direction of the mating axis Y. The test probe 1 is deflected up to a position at which the centre axis X is aligned with the mating axis Y. The distance D between the mating axis Y and the centre axis X may have a maximum value of 0.5 mm.

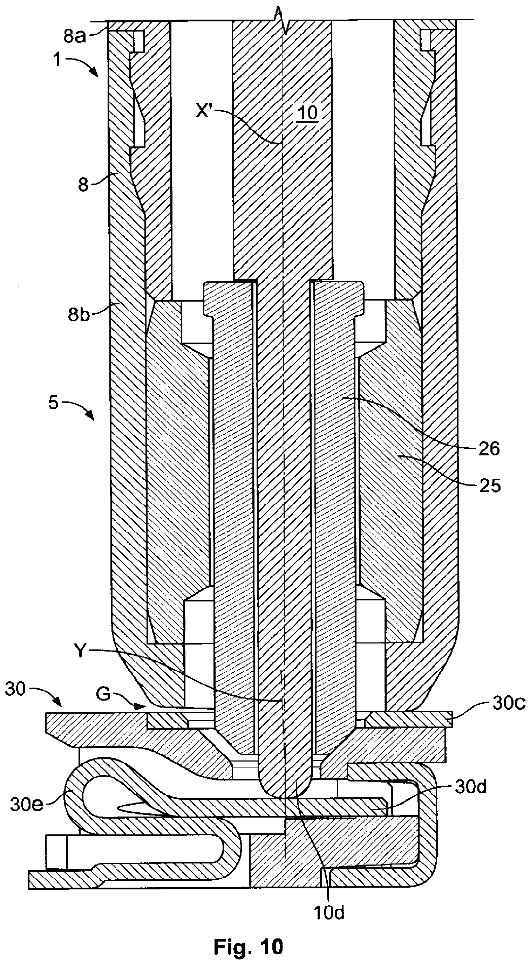

Fig.10 is a schematic cross sectional view of a test probe 1 and a connector 30 at a mated state. The rounded tip 10d is electrically connected to a switching leg 30d of a contact spring 30e. The distal part 8b of the outer contact portion 8b rests on a ground contact 30c and thereby is electrically connected to the ground contact 30c. Due to the misalignment of the centre axis X in relation to the mating axis Y as shown in Fig. 9, the outer contact portion 8 is deflected in relation to the (here not shown) housing. From the deflection of the outer contact portion 8 or the insertion portion 5 a gap G between the outer contact portion 8 and the ground contact 30c results which corresponds to the inclination of the insertion portion 5.

As the bushing 26 is adapted to slide on the inner contact portion 10, its position may adapt automatically to the position of the connector 30. If the insertion portion 5 is deflected due to a misalignment of the center axis X in relation to the mating axis Y, there may remain an angle between the center axis X' of the insertion portion 5 and the mating axis Y. Then, while mating the test probe 1 to the connector 30, the tapered section 26c abuts the funnel-shaped section 30f before the inner contact portion 10 has reached its mating position as shown in fig. 10. Due to the mobility or slidability of the bushing 26, the inner contact portion 10 is not stopped when bushing 26 abuts the connector 30 and can move up to its mating position.

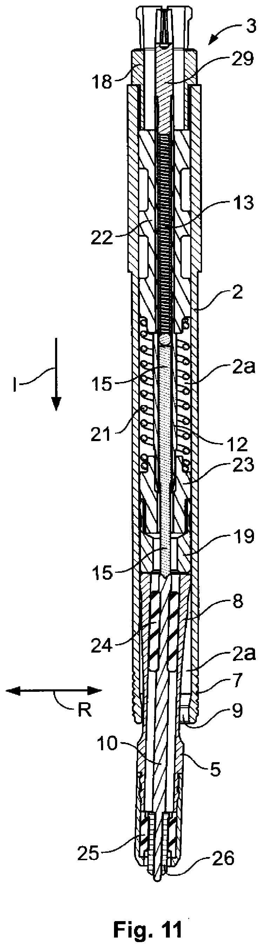

Fig. 11 is a cross sectional view of a middle portion of the test probe 1 according to the invention. The outer contact portion 8 and the inner contact portion 10 are maximally deflected in a radial direction R. At the maximal deflection the outer contact portion 5 abuts the inner surface of the recess 2a of the housing 2. As the outer shape of the outer contact portion 5 tapers at least sectionally in insertion direction I. As the outer diameter of the outer contact portion tapers in insertion direction I, the maximum deflection of the insertion portion in a radial direction R may be independent of the movement of the insertion portion 5 in or against the insertion direction I.

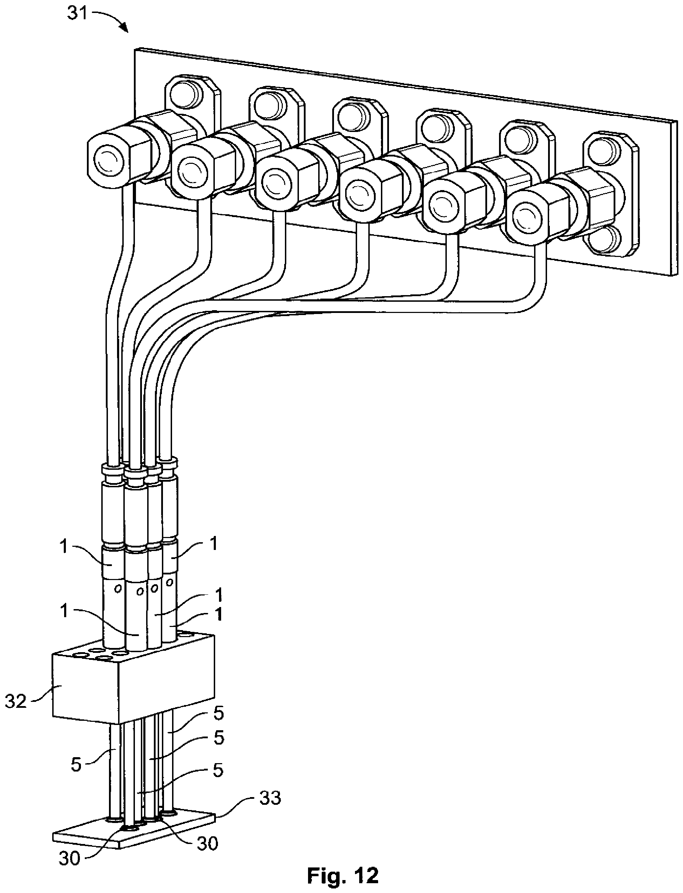

Fig. 12 is a perspective schematic view of a testing assembly comprising a plurality of test probes according to the invention. A plurality of test probes 1 is mounted on an adaptor plate 32. As the test probes are shown in a mated state the insertion portions 5 are positioned on a printed circuit board 33, each insertion portion 5 situated in a connector 30. Due to the small dimensions of the test probes 1 a high number of test probes 1 can be arranged in an adaptor plate 32, using less space for testing miniaturized circuits.

## Claims

1. Test probe (1) for mating with a connector (30) in a probe insertion direction (I), comprising:
a housing (2),
an outer contact portion (8), the outer contact portion (8) supported by the housing (2) and extending away from the housing (2),
said outer contact portion (8) supported by an elastically deformable outer biasing means (21) and being adapted to be deflected substantially perpendicular to the probe insertion direction (I),
at least one contact assurance means (19), said at least one contact assurance means (19) connecting the outer contact portion (8) electrically conductively to the housing (2) and having at least one contact section (19c), said contact section (19c) pressed conductively against the housing (2) by being elastically deflected, **characterized in that** the at least one contact assurance means (19) is received by the housing (2) slidingly in the insertion direction (I).

2. Test probe (1) according to claim 1, **characterized in that** the at least one contact assurance means (19) is adapted to rotate substantially perpendicularly to the probe insertion direction (1).

3. Test probe (1) according to claim 1 or 2, **characterized in that** the outer biasing means (21) is adapted to generate a restoring force upon deformation, the at least one assurance means (19) interposed between the outer biasing means (21) and the outer contact portion (8) in the restoring force flux.

4. Test probe (1) according to one of the claims 2 to 3, **characterized in that** the test probe (2) comprises at least one guiding element (23), said guiding element (23) arranged movable in an axial direction (A) in a recess (2a) of the housing (2) and disposed in the force flux which is directed from the outer biasing means (21) to the at least one contact assurance means (19).

5. Test probe (1) according to one of the claims 1 to 4, **characterized in that** the outer contact portion (8) has a support portion (8i), said support portion (8i) being arranged within the housing (2) and at an initial state of the test probe (2) pressed by the outer biasing means (21) onto a support face (2b) of the housing (2), the support portion (8i) and/or the support face (2b) adapted to generate an aligning force to align the contact portion (8) with the insertion direction (1).

6. Tet probe (1) according to one of the claims 1 to 5, **characterized in that** an external dimension of the outer contact portion (8) is at least in one section adjacent to the support portion (8i) tapering in insertion direction (I).

7. Test probe (1) according to one of the claims 1 to 6, **characterized in that** the inner contact portion (10) is connected to the housing (2) by an elastically deformable inner biasing means (13), said inner biasing means (13) being adapted to exert a restoring force on the inner contact portion (10), said restoring force directed to the insertion direction (I).

8. Test probe (1) according to claim 7, **characterized in that** the test probe (1) comprises a guidance (12) and an inner guiding element (15), said guidance (12) having an inner guiding recess (12c), the inner guiding element (15) connected movably in an axial direction (A) to the inner guiding recess (12c), the inner guiding element (15) extending away from the guidance (12) in insertion direction (I) and transmitting the restoring force from the inner biasing means (13) to the inner contact portion (10).

9. Test probe (1) according to claim 8, **characterized in that** the guiding element (23) has a recess (23d, 23g) adapted to receive at a mated state of the test probe (1) at least a portion of the guidance (12).

10. Test probe (1) according to claim 8 or 9, **characterized in that** the guidance (12) is provided with a stop (12d, 12e), said stop (12d, 12e) adapted to interfere with the guiding element (23) at a predetermined end position of the guiding element (23).

11. Test probe (1) according to one of the claims 1 to 10, **characterized in that** the ratio of the maximum deflection perpendicular to the insertion direction (I) of the end of the outer contact portion (8) pointing to the insertion direction (I) to the largest diameter of the section of the outer contact portion (8) extending out of the housing (2) is about 1/24 to 4/24, preferably 1/8.

12. Test probe (1) according to one of the claims 1 to 11, **characterized in that** the ratio of the maximum upstroke of the insertion portion (5) to the length of the housing (2) in insertion direction (I) is about 2/15 to 4/15, preferably 1/5.

13. Test probe (1) according to one of the claims 1 to 12, **characterized in that** the outer contact portion (8) and/or the inner contact portion (10) are adapted to be deflected in an axial direction (A) up to at least ½ length of the section of the outer contact portion (8) extending out of the housing (2).

14. Test probe (1) according to one of the claims 1 to 13, **characterized in that** the end of the outer contact portion (8) pointing in insertion direction (I) is substantially cone shaped.

## Patentansprüche

1. Prüfsonde (1) zum Zusammenfügen mit einem Verbinder (30) in einer Sondeneinführrichtung (I), umfassend:
ein Gehäuse (2),
einen äußeren Kontaktabschnitt (8), wobei der äußere Kontaktabschnitt (8) von dem Gehäuse (2) gehalten ist und sich von dem Gehäuse (2) weg erstreckt,
wobei der äußere Kontaktabschnitt (8) durch eine elastisch verformbare äußere Vorspanneinrichtung (21) gehalten ist und im wesentlichen senkrecht zur Sondeneinführrichtung (I) abgelenkt werden kann,
wenigstens eine Kontaktsicherungseinrichtung (19), wobei die wenigstens eine Kontaktsicherungseinrichtung (19) den Außenkontaktabschnitt (8) elektrisch leitend mit dem Gehäuse (2) verbindet und wenigstens einen Kontaktabschnitt (19c) aufweist, wobei der Kontaktabschnitt (19c) durch elastisches Ablenken gegen das Gehäuse (2) gedrückt wird,
**dadurch gekennzeichnet, dass**
die wenigstens eine Kontaktsicherungseinrichtung (19) von dem Gehäuse (2) gleitfähig in der Einführrichtung (I) aufgenommen ist.

2. Prüfsonde (1) nach Anspruch 1, **dadurch gekennzeichnet, dass** die wenigstens eine Kontaktsicherungseinrichtung (19) dazu eingerichtet ist, sich im wesentlichen senkrecht zur Sondeneinführrichtung (I) zu drehen.

3. Prüfsonde (1) nach Anspruch 1 oder 2, **dadurch gekennzeichnet, dass** die äußere Vorspanneinrichtung (21) dazu eingerichtet ist, bei einer Verformung eine Rückstellkraft zu erzeugen, wobei die wenigstens eine Kontaktsicherungseinrichtung (19) zwischen der äußeren Vorspanneinrichtung (21) und dem äußeren Kontaktabschnitt (8) in Rückstellkraftrichtung angeordnet ist.

4. Prüfsonde (1) nach einem der Ansprüche 2 bis 3, **dadurch gekennzeichnet, dass** die Prüfsonde (2) wenigstens ein Führungselement (23) umfasst, wobei das Führungselement (23) beweglich in axialer Richtung (A) in einer Ausnehmung (2a) des Gehäuses (2) angebracht ist und in der Kraftrichtung angeordnet ist, die von der äußeren Vorspanneinrichtung (21) zu der wenigstens einen Kontaktsicherungseinrichtung (19) gerichtet ist.

5. Prüfsonde (1) nach einem der Ansprüche 1 bis 4, **dadurch gekennzeichnet, dass** der äußere Kontaktabschnitt (8) einen Halteabschnitt (8i) aufweist, wobei der Halteabschnitt (8i) innerhalb des Gehäuses (2) angeordnet ist und in einem Ausgangszustand der Prüfsonde von der äußeren Vorspanneinrichtung (21) auf eine Haltefläche (2b) des Gehäuses (2) gepresst wird, wobei der Halteabschnitt (8i) und/oder die Haltefläche (2b) dazu eingerichtet sind, eine Ausrichtkraft zu erzeugen, um den Kontaktabschnitt (8) mit der Einführrichtung (I) auszurichten.

6. Prüfsonde (1) nach einem der Ansprüche 1 bis 5, **dadurch gekennzeichnet, dass** sich eine äußere Abmessung des äußeren Kontaktabschnittes (8) zumindest in einem Abschnitt benachbart zu dem Halteabschnitt (8i) in der Einführrichtung verjüngt.

7. Prüfsonde (1) nach einem der Ansprüche 1 bis 6, **dadurch gekennzeichnet, dass** der innere Kontaktabschnitt (10) mit dem Gehäuse (2) durch eine elastisch verformbare innere Vorspanneinrichtung (13) verbunden ist, wobei die innere Vorspanneinrichtung (13) eine Rückstellkraft auf den inneren Kontaktabschnitt (10) ausüben kann, wobei die Rückstellkraft auf die Einführrichtung (I) gerichtet ist.

8. Prüfsonde (1) nach Anspruch 7, **dadurch gekennzeichnet, dass** die Prüfsonde (1) eine Führung (12) und ein inneres Führungselement (15) umfasst, wobei die Führung (12) eine innere Führungsausnehmung (12c) aufweist, wobei das innere Führungselement (15) in axialer Richtung (A) mit der inneren Führungsausnehmung (12c) bewegbar verbunden ist, wobei sich das innere Führungselement (15) in der Einführrichtung (I) von der Führung (12) weg erstreckt und die Rückstellkraft von der inneren Vorspanneinrichtung (13) zu dem inneren Kontaktabschnitt (10) überträgt.

9. Prüfsonde (1) nach Anspruch 8, **dadurch gekennzeichnet, dass** das Führungselement (23) eine Ausnehmung (23d, 23g) aufweist, die in einem zusammengesetzten Zustand der Prüfsonde (1) wenigstens einen Teil der Führung (12) aufnehmen kann.

10. Prüfsonde (1) nach Anspruch 8 oder 9, **dadurch gekennzeichnet, dass** die Führung (12) mit einem Anschlag (12d, 12e) versehen ist, wobei der Anschlag (12d, 12e) mit dem Führungselement (23) an einer vorgegebenen Endstellung des Führungselementes (23) in Anlage gelangen kann.

11. Prüfsonde (1) nach einem der Ansprüche 1 bis 10, **dadurch gekennzeichnet, dass** das Verhältnis der maximalen Ablenkung senkrecht zur Einführrichtung (I) des in Einschubrichtung weisenden Endes des äußeren Kontaktabschnittes (8) (I) zum größten Durchmesser des aus dem Gehäuse (2) herausragenden Abschnittes des äußeren Kontaktabschnittes (8) etwa 1/24 bis 4/24, vorzugsweise jedoch 1/8 beträgt.

12. Prüfsonde (1) nach einem der Ansprüche 1 bis 11, **dadurch gekennzeichnet, dass** das Verhältnis des maximalen Aufwärtshubes des Einführabschnittes (5) zur Länge des Gehäuses (2) in Einführrichtung (I) etwa 2/15 bis 4/15, vorzugsweise jedoch 1/5 beträgt.

13. Prüfsonde (I) nach einem der Ansprüche 1 bis 12, **dadurch gekennzeichnet, dass** der äußere Kontaktabschnitt (8) und/oder der innere Kontaktabschnitt (10) in axialer Richtung (A) nach außen bis wenigstens die Hälfte der Länge des aus dem Gehäuse (2) herausragenden Abschnittes des äußeren Kontaktabschnittes (8) abgelenkt werden können.

14. Prüfsonde (1) nach einem der Ansprüche 1 bis 13, **dadurch gekennzeichnet, dass** das Ende des äußeren Kontaktabschnittes (8), das in die Einführrichtung (I) weist, im wesentlichen konusförmig ist.

## Revendications

1. Sonde (1) de test destinée à s'accoupler avec un connecteur (30) dans une direction (I) d'insertion de sonde, comportant :
un logement (2),
une partie (8) contact externe, la partie (8) contact externe étant supportée par le logement (2) et s'étendant à distance du logement (2),
ladite partie (8) contact externe supportée par un moyen (21) de sollicitation externe élastiquement déformable et conçue pour être déviée sensiblement perpendiculairement à la direction (I) d'insertion de sonde,
au moins un moyen (19) de garantie de contact, ledit au moins un moyen (19) de garantie de contact reliant la partie (8) contact externe de manière électroconductrice au logement (2) et présentant au moins une section (19c) de contact, ladite section (19c) de contact étant pressée de manière conductrice contre le logement (2) en étant élastiquement déviée, **caractérisée en ce que**
au moins un moyen (19) de garantie de contact est reçu par le logement (2) à coulissement dans la direction (I) d'insertion.

2. Sonde (1) de test selon la revendication 1, **caractérisée en ce que** ledit au moins un moyen (19) de garantie de contact est conçu pour tourner sensiblement perpendiculairement à la direction (I) d'insertion de sonde.

3. Sonde (1) de test selon la revendication 1 ou 2, **caractérisée en ce que** le moyen (21) de sollicitation externe est conçu pour générer une force de rappel au moment de la déformation, ledit au moins un moyen (19) de garantie étant interposé entre le moyen (21) de sollicitation externe et la partie (8) contact externe dans le flux de la force de rappel.

4. Sonde (1) de test selon l'une quelconque des revendications 2 à 3, **caractérisée en ce que** la sonde (2) de test comporte au moins un élément (23) de guidage, ledit élément (23) de guidage étant agencé mobile dans une direction (A) axiale dans un évidement (2a) du logement (2) et disposé dans le flux de la force qui est dirigée du moyen (21) de sollicitation externe audit au moins un moyen (19) de garantie de contact.

5. Sonde (1) de test selon l'une quelconque des revendications 1 à 4, **caractérisée en ce que** la partie (8) contact externe présente une partie (8i) support, ladite partie (8i) support étant agencée à l'intérieur du logement (2) et, à un état initial de la sonde (2) de test, étant pressée par le moyen (21) de sollicitation externe sur une face (2b) support du logement (2), la partie (8i) support et/ou la face (2b) support étant conçues pour générer une force d'alignement afin d'aligner la partie (8) contact avec la direction (I) d'insertion.

6. Sonde (1) de test selon l'une quelconque des revendications 1 à 5, **caractérisée en ce qu'**une dimension extérieure de la partie (8) contact externe est au moins dans une section adjacente à la partie (8i) support, diminuant progressivement dans la direction (I) d'insertion.

7. Sonde (1) de test selon l'une quelconque des revendications 1 à 6, **caractérisée en ce que** la partie (10) contact interne est reliée au logement (2) par un moyen (13) de sollicitation interne élastiquement déformable, ledit moyen (13) de sollicitation interne étant conçu pour exercer une force de rappel sur la partie (10) contact interne, ladite force de rappel étant dirigée dans la direction (I) d'insertion.

8. Sonde (1) de test selon la revendication 7, **caractérisée en ce que** la sonde (1) de test comporte un guidage (12) et un élément (15) de guidage interne, ledit guidage (12) présentant un évidement (12c) de guidage interne, l'élément (15) de guidage interne étant relié mobile dans une direction (A) axiale vers l'évidement (12c) de guidage interne, l'élément (15) de guidage interne s'étendant à distance du guidage (12) dans la direction (I) d'insertion et transmettant la force de rappel du moyen (13) de sollicitation interne à la partie (10) contact interne.

9. Sonde (1) de test selon la revendication 8, **caractérisée en ce que** l'élément (23) de guidage présente un évidement (23d, 23g) conçu pour recevoir, à un état accouplé de la sonde (1) de test, au moins une partie du guidage (12).

10. Sonde (1) de test selon la revendication 8 ou 9, **caractérisée en ce que** le guidage (12) est fourni avec une butée (12d, 12e), ladite butée (12d, 12e) étant conçue pour faire obstacle à l'élément (23) de guidage à une position d'extrémité prédéterminée de l'élément (23) de guidage.

11. Sonde (1) de test selon une quelconque des revendications 1 à 10, **caractérisée en ce que** le rapport entre la déviation maximale perpendiculaire à la direction (I) d'insertion de l'extrémité de la partie (8) contact externe orientée vers la direction (I) d'insertion et le plus grand diamètre de la section de la partie (8) contact externe qui s'étend hors du logement (2) est d'environ 1/24 à 4/24, de préférence 1/8.

12. Sonde (1) de test selon l'une quelconque des revendications 1 à 11, **caractérisée en ce que** le rapport entre la course maximale de la partie (5) d'insertion et la longueur du logement (2) dans la direction (1) d'insertion est d'environ 2/15 à 4/15, de préférence 1/5.

13. Sonde (1) de test selon l'une quelconque des revendications 1 à 12, **caractérisée en ce que** la partie (8) contact externe et/ou la partie (10) contact interne sont conçues pour être déviées dans une direction (A) axiale jusqu'à au moins une ½ longueur de la section de la partie (8) contact externe qui s'étend hors du logement (2).

14. Sonde (1) de test selon l'une quelconque des revendications 1 à 13, **caractérisée en ce que** l'extrémité de la partie (8) contact externe orientée dans la direction (I) d'insertion est sensiblement en forme de cône.
